# EUROPEAN PATENT APPLICATION

(11) **EP 4 282 648 A1**
(43) Date of publication of application: **29.11.2023**
(21) Application number: 22742598.0
(22) Date of filing: 19.01.2022
(51) Int. Cl.: B32B 15/08, B29B 11/16, C08J 5/24, C23C 18/31, C25D 1/04

(54) **PREPREG WITH METAL LAYER, METHOD FOR MANUFACTURING LAMINATE, AND METHOD FOR MANUFACTURING PREPREG WITH METAL LAYER**

(30) Priority: 19.01.2021 JP 2021006594
(71) Applicant: Sasaki, Beji, Tokyo 101-0042 (JP)
(72) Inventor: Sasaki, Beji, Tokyo 101-0042 (JP)
(74) Representative: Hindles Limited
(86) International application number: PCT/JP2022/001732
(87) International publication number: WO 2022/158476

(57) **Abstract**

A prepreg 100 with a metal layer has the metal layer 20 having a thickness of 11 um or less; and the prepreg 10 provided on the metal layer 20. A carrier layer for supporting the metal layer 20 is not provided.

## Description

### Technical Field

The present invention relates to a prepreg with a metal layer, a laminating manufacturing method, and a method for manufacturing the prepreg with a metal layer.

### Background Art

Hitherto, a copper foil with a carrier is known. For example, JP 2019-31739 A discloses a copper foil with a carrier including a carrier layer, an intermediate layer provided on the carrier layer, a release layer provided on the intermediate layer, and an ultrathin copper layer provided on the release layer.

Such a copper foil with a carrier is placed on a prepreg and heated to make the carrier layer and the intermediate layer peelable from the release layer, and the carrier layer and the intermediate layer are removed to use only the ultrathin copper layer.

As the carrier is provided, handling of the copper foil with a carrier according to the related art is facilitated. Since the ultrathin copper layer itself has a small thickness, it is very difficult to handle and practically impossible to handle the ultrathin copper layer. Therefore, the carrier is provided to enable handling.

### SUMMARY OF INVENTION

### PROBLEM TO BE SOLVED BY INVENTION

The present invention provides a technology for eliminating waste and improving working efficiency as compared with the copper foil with a carrier according to the related art.

### MEANS FOR SOLVING PROBLEM

A prepreg with a metal layer according to the present invention may comprise:
the metal layer having a thickness of 11 um or less; and
the prepreg provided on the metal layer,
wherein a carrier layer for supporting the metal layer may not be provided.

In the prepreg with the metal layer according to the present invention,
the prepreg may have a fiber layer and a resin layer provided on the fiber layer, and
the resin layer may be in a semi-cured state and has a surface having a concavo-convex shape.

In the prepreg with the metal layer according to the present invention,
a peak intensity of the largest peak in XRD measurement for the resin layer of the prepreg may be 1/3 or less as compared with a peak intensity of the largest peak in XRD measurement for the prepreg in which the resin layer is completely cured.

The metal layer may have a thickness of 5 um or less, may have a thickness of 3 um or less in a thinner case, and may have a thickness of 1 um or less if a further thinner case.

A laminate may be manufactured by laminating the above prepregs with the metal layers.

A method for manufacturing a prepreg with a metal layer may comprise:
a step of forming the metal layer on a carrier layer having a surface on which an adhesive that is thermally degraded is provided;
a step of providing a thermosetting prepreg on a surface of the metal layer opposite from the carrier layer;
a step of curing the prepreg and degrading the adhesive by heating; and
a step of removing the carrier layer and the adhesive.

The method may further comprise
a step of oxidizing or reducing the surface of the metal layer opposite from the carrier layer between the step of forming the metal layer and the step of providing the prepreg.

By adopting an aspect in which a carrier layer for supporting a metal layer is not provided as in the present invention, waste can be eliminated and working efficiency can be improved as compared with a copper foil with a carrier including a carrier layer.

### Brief Description of Drawings

Fig. 1 is a cross-sectional view of a prepreg having one surface on which a metal layer is provided according to an embodiment of the present invention.
Fig. 2 is a cross-sectional view of a laminate according to an embodiment of the present invention.
Fig. 3 is a cross-sectional view illustrating Laminate Manufacturing Example 1 according to an embodiment of the present invention.
Fig. 4 is a cross-sectional view illustrating Laminate Manufacturing Example 2 according to an embodiment of the present invention.
Fig. 5 is a cross-sectional view illustrating Laminate Manufacturing Example 3 according to an embodiment of the present invention.
Fig. 6 is a cross-sectional view of a prepreg having both surfaces on which metal layers are provided according to an embodiment of the present invention.
Fig. 7 is a cross-sectional view for describing a process of manufacturing the prepreg having one surface on which the metal layer is provided according to the embodiment of the present invention.
Fig. 8 is a cross-sectional view for describing a process of manufacturing the prepreg having both surfaces on which the metal layers are provided according to an embodiment of the present invention.
Fig. 9 is a cross-sectional view of a prepreg with a metal layer provided with an adhesive layer according to an embodiment of the present invention.
Fig. 10 is a cross-sectional view of a prepreg with a metal layer provided with an oxide layer according to an embodiment of the present invention.
Fig. 11 is a cross-sectional view illustrating an example of a method for manufacturing the prepreg with a metal layer according to an embodiment of the present invention.
Fig. 12 is a cross-sectional view illustrating another example of the method for manufacturing the prepreg with a metal layer according to an embodiment of the present invention.
Fig. 13A illustrates a scanning electron microscope (SEM) image (x2000 magnification) of a resin layer in a state in which semi-curing at 120°C has not progressed much.
Fig. 13B illustrates an SEM image (x5000 magnification) of the resin layer in a state in which semi-curing at 120°C has not progressed much.
Fig. 14A illustrates an SEM image (x2000 magnification) of the resin layer in an appropriate semi-cured state at 150°C.
Fig. 14B illustrates an SEM image (x5000 magnification) of the resin layer in the appropriate semi-cured state at 150°C.
Fig. 15A illustrates an SEM image (x2000 magnification) of the resin layer in a cured state.
Fig. 15B illustrates an SEM image (x5000 magnification) of the resin layer in the cured state.
Fig. 16 illustrates an X-ray diffraction (XRD) measurement result for the resin layer in a state in which semi-curing at 120°C has not progressed much.
Fig. 17 illustrates an XRD measurement result for the resin layer in the appropriate semi-cured state at 150°C.
Fig. 18 illustrates an XRD measurement result for the resin layer in the cured state at 190°C.
Fig. 19 is a cross-sectional view of an example of the prepreg according to an embodiment of the present invention.
Fig. 20A is a plan view illustrating an example of a first fiber layer that can be used in an embodiment of the present invention.
Fig. 20B is a plan view illustrating an example of a second fiber layer that can be used in an embodiment of the present invention.
Fig. 21 is a cross-sectional view of another example of the prepreg according to an embodiment of the present invention.

### DETAILED DESCRIPTION

### Embodiment

### <<Configuration>>

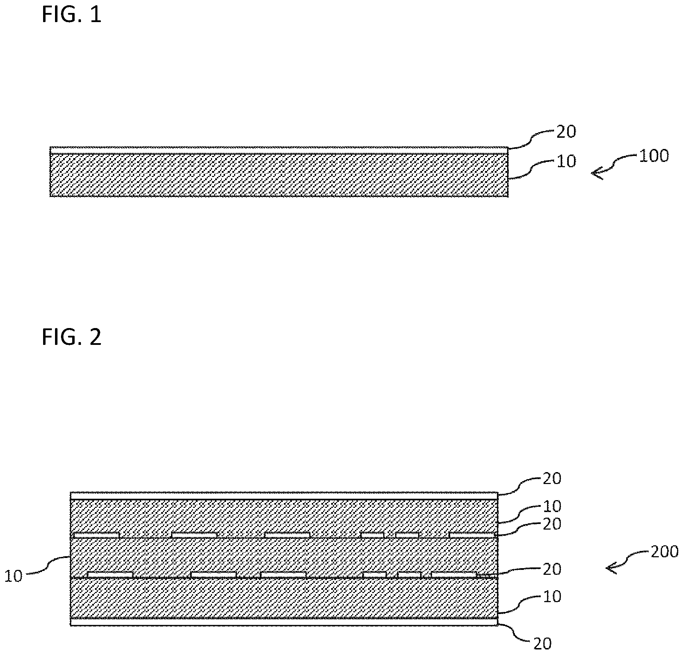

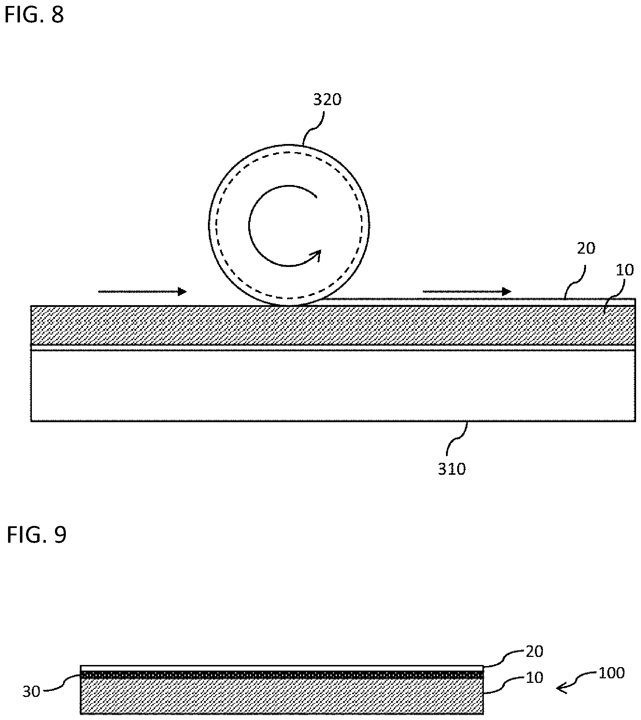

As illustrated in Fig. 1, a prepreg 100 with a metal layer according to the present embodiment may have a metal layer 20 having a thickness of 11 um or less, and a prepreg 10 in a semi-cured state on which the metal layer 20 is provided. The prepreg 100 with a metal layer according to the present embodiment is not provided with a carrier layer for supporting the metal layer 20. The metal layer 20 is, for example, a metal foil such as a copper foil. An adhesive layer 30 may be provided between the metal layer 20 and the prepreg 10 (see Fig. 9). Patent Literature 1 ([0016]) discloses that "a thickness of a carrier is preferably 100 to 2000 µm, more preferably 300 to 1800 µm, and still more preferably 400 to 1100 µm", but the thickness of the metal layer 20 of the present embodiment is much smaller than the thickness of the carrier.

The expression "semi-cured state" in the present embodiment means a state of having a certain shape unlike a liquid, being not completely cured, and being deformable by pressing, for example. The metal layer 20 can be embedded by using the prepreg 10 in the semi-cured state. The prepreg 10 does not have to be in the semi-cured state and may be in a cured state.

A resin material can be used as a material of the prepreg 10. For example, an epoxy resin may be used as the resin material. The resin material is not limited thereto, and an unsaturated polyester resin, a vinyl ester resin, a bismaleimide resin, a benzoxazine resin, a triazine resin, a phenol resin, a urea resin, a melamine resin, a polyimide resin, a polyolefin-based resin, an aliphatic polyamide-based resin, a semi-aromatic polyamide-based resin, an aromatic polyester-based resin, a polycarbonate-based resin, a polystyrene-based resin, or the like may be used as the resin material.

In the present embodiment, since the prepreg 10 in the semi-cured state serves to replace a carrier layer according to the related art, it is not necessary to provide the carrier layer. According to the related art, the carrier layer is provided to facilitate handling such as conveyance. In a case where there is no carrier layer, inconvenience such as wrinkling of the copper foil or breakage of the copper foil occurs during conveyance, and thus, the carrier layer is an indispensable constituent element.

Such a carrier layer is finally discarded, and it cannot thus be denied that waste occurs. On the other hand, according to the present embodiment, since such a carrier layer is not provided, and the prepreg 10 in the semi-cured state functions as the carrier layer, it is extremely excellent in that handling such as conveyance becomes possible. The prepreg 10 according to the present embodiment is not necessarily in the semi-cured state, and may be a completely cured solid.

According to the present embodiment, it is extremely advantageous also when manufacturing a multilayer plate (multilayer wiring board) 200 as illustrated in Fig. 2. According to the related art, an operation of stacking a copper foil with a carrier on the prepreg 10 and then removing the carrier layer is performed. On the other hand, according to the present embodiment, it is extremely advantageous in that it is possible to form the multilayer plate by simply stacking the prepregs 100 with a metal layer and it is not necessary to perform an operation of removing the carrier layer.

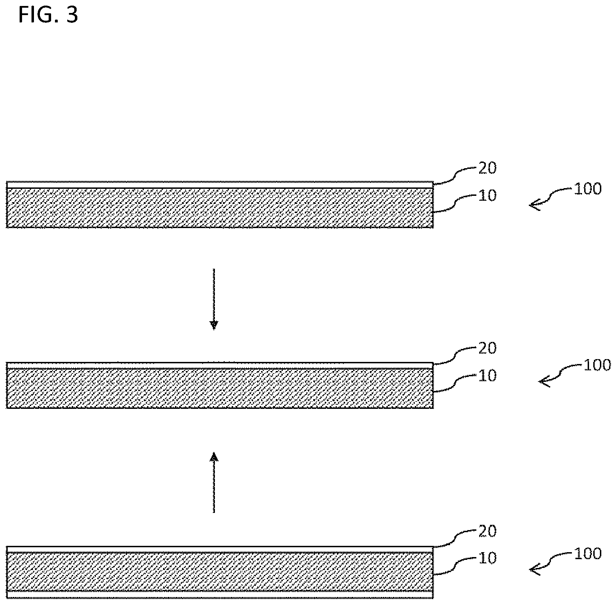

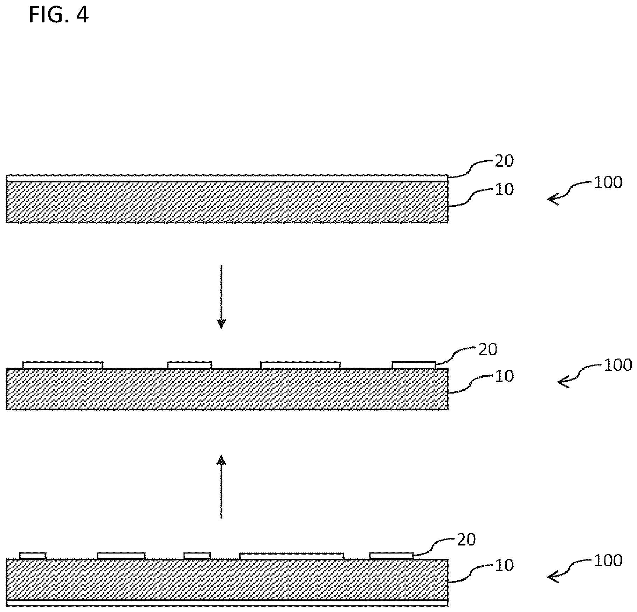

That is, as illustrated in Fig. 3, since the carrier layer is not provided, the multilayer plate can be formed by simply stacking the prepregs 100 with a metal layer. As illustrated in Fig. 4, the prepreg 100 with a metal layer may be stacked after a circuit is appropriately formed.

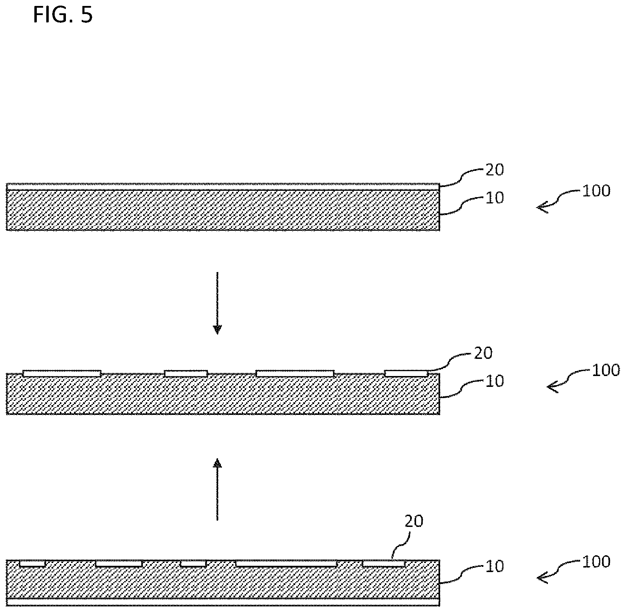

As illustrated in Fig. 5, the multilayer plate 200 may be manufactured by stacking the prepregs 100 with a metal layer while embedding a part of or the entire circuit (see the prepregs 100 with a metal layer in the middle and on the lowermost side of Fig. 5).

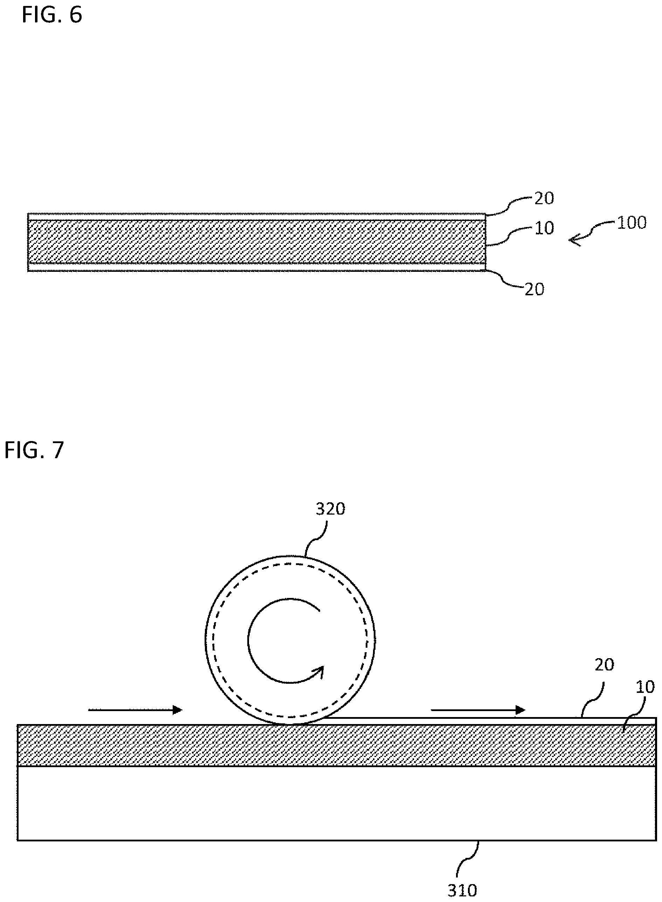

As illustrated in Fig. 6, the metal layers 20 may be provided on both surfaces of the prepreg 10. It should be noted here that such a prepreg 10 is not made of a metal foil with a carrier having a carrier layer. In the present embodiment, the metal layer 20 having no carrier layer is provided on the prepreg 10.

The reason why the carrier layer is required is that a company that provides the copper foil and a company that manufactures the circuit board are different from each other, but the inventor of the present application has an environment (company) in which these operations can be performed integrally. As a result, the copper foil is provided on the prepreg 10 in the semi-cured state, and then manufacturing of the multilayer plate, circuit design, and the like can be performed in this state in the own company.

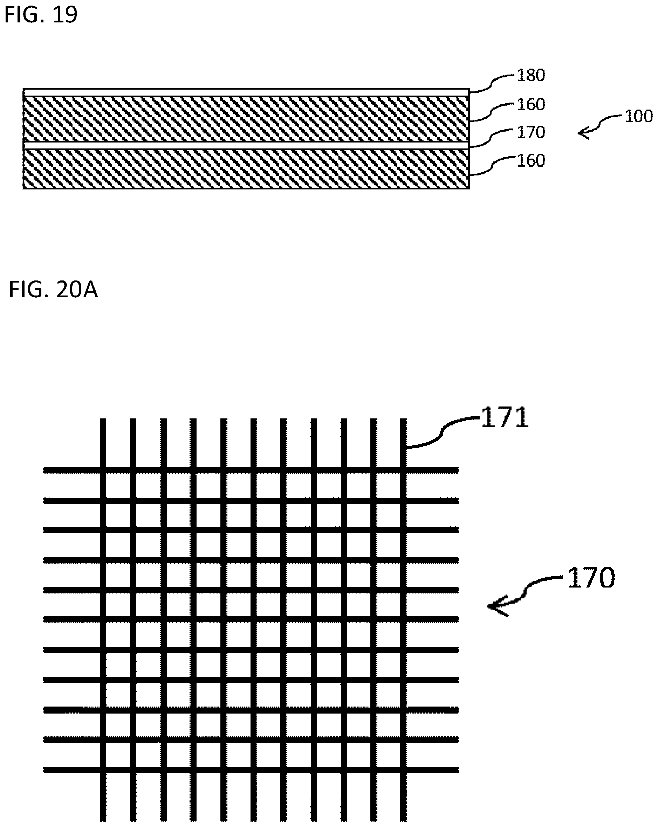

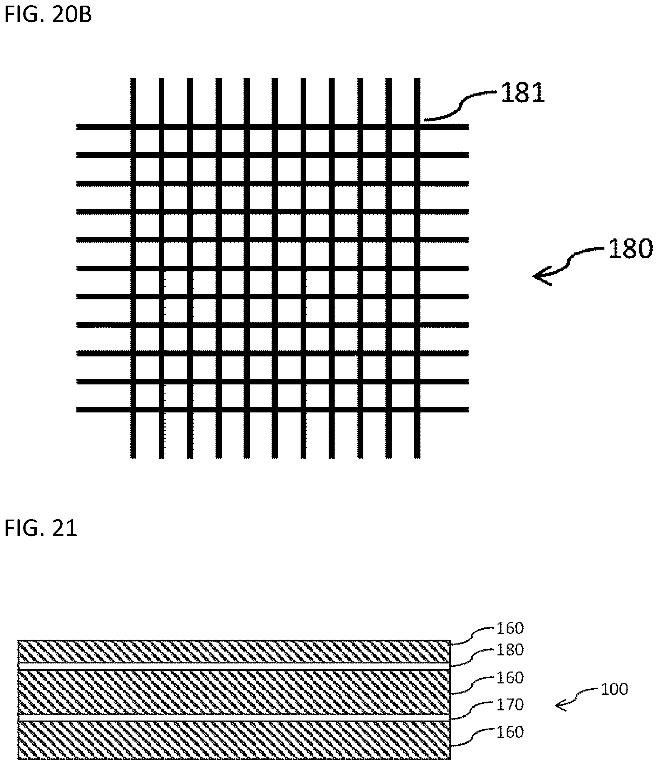

As illustrated in Fig. 19, the prepreg 100 of the present embodiment may have a first fiber layer 170 made of a first fiber 171, and a second fiber layer 180 separated from the first fiber layer 170 in a thickness direction and made of a second fiber 181. Resin layers 160 may be formed by providing the resin material on a side of the first fiber layer 170 that faces the second fiber layer 180 (an upper side in Fig. 19) and a side of the first fiber layer 170 opposite from the second fiber layer 180 (a lower side in Fig. 19). As illustrated in Fig. 21, the fiber layers such as the first fiber layer 170 and the second fiber layer 180 may be embedded in the resin layer 160.

As illustrated in Fig. 20A, the first fiber layer 170 may be formed by interweaving the first fiber 171. Similarly, as illustrated in Fig. 20B, the second fiber layer 180 may be formed by interweaving the second fiber 181. Three or more fiber layers may be provided, and up to n fiber layers ("n" is an integer of 3 or more) may be provided, and resin layers may be provided corresponding to the respective fiber layers.

As the fiber, for example, a glass fiber, a liquid crystal polyester fiber, an aromatic polyamide fiber, a polyparaphenylene benzobisoxazole (PBO) fiber, a polyphenylene sulfide (PPS) fiber, a carbon fiber, and the like can be used. As a glass material of the glass fiber, T glass, S glass, D glass, E glass, NE glass, C glass, H glass, ARG glass, quartz glass, or the like can be used.

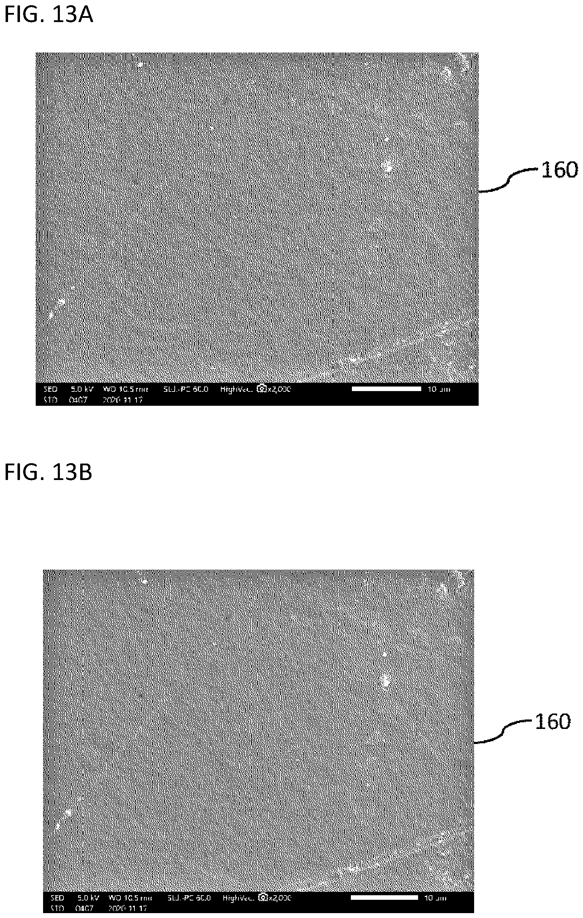

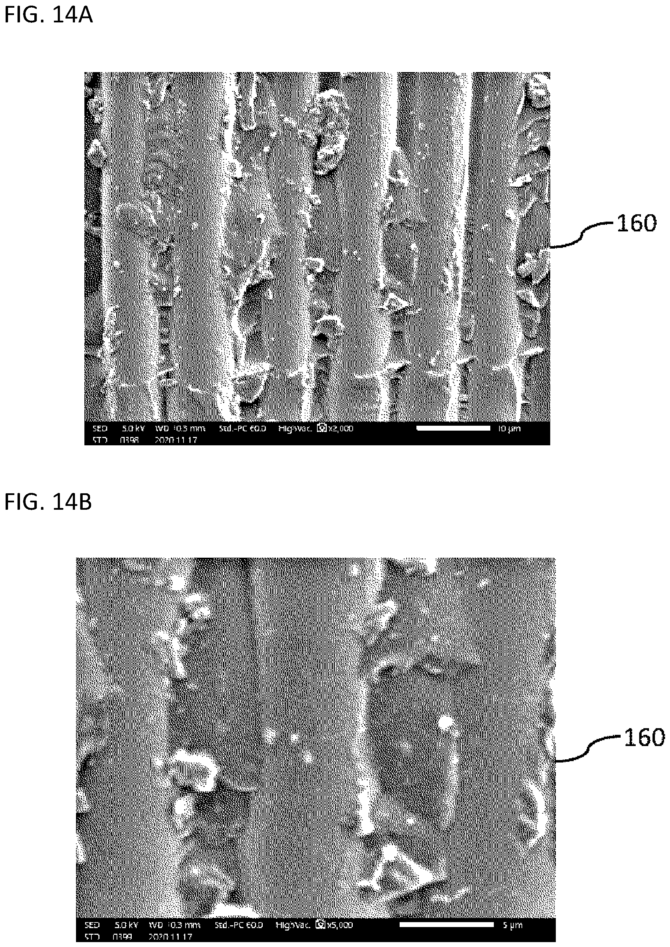

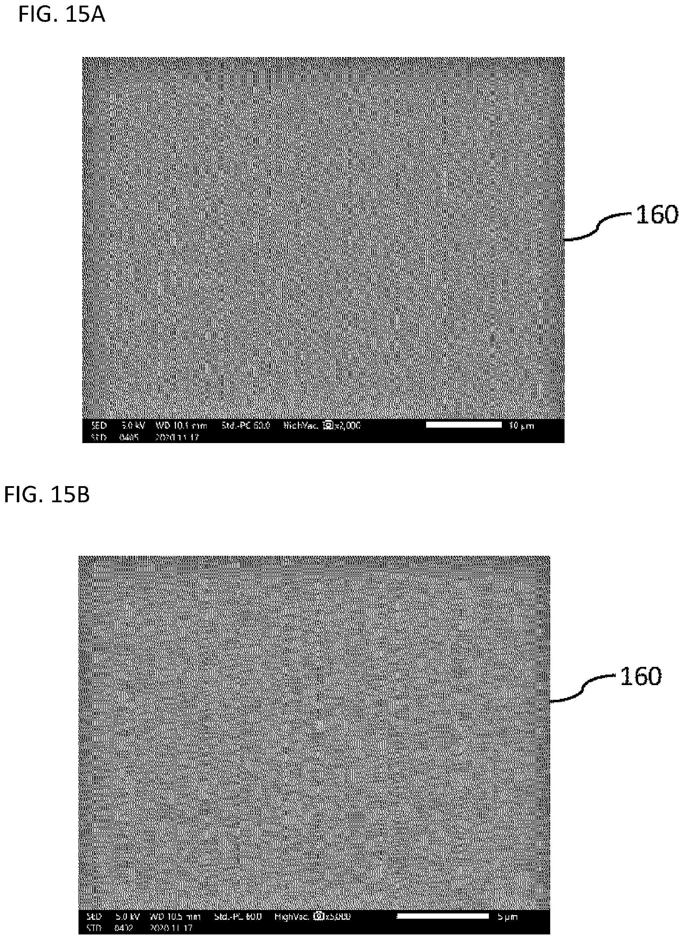

The resin layer 160 of the prepreg 100 in the semi-cured state including the fiber layers such as the first fiber layer 170 and the second fiber layer 180 may have a concavo-convex shape on a surface thereof as illustrated in Figs. 14A and 14B. The fiber layers may be embedded in the resin layer 160 in the semi-cured state (see Fig. 21), and concavo-convex shape may be formed on the surface of the resin layer 160 where the fiber layers are positioned. The prepreg 100 in the semi-cured state having the concavo-convex shape as described above has a preferable hardness, and is extremely suitable for embedding a patterned circuit. In addition, inclusion of the fiber layers is also advantageous in terms of having shape stability. Figs. 13A and 13B illustrate a state in which the temperature is lower than that in Figs. 14A and 14B, and the semi-curing has not progressed to an appropriate state. Figs. 15A and 15B illustrate the prepreg 100 in the cured state, and no concavo-convex shape is observed on the surface. By lowering the temperature after the state as illustrated in Figs. 13A and 13B, it is possible to provide the prepreg 100 including the resin layer 160 having a concavo-convex shape on the surface. In addition, the prepreg may be selected after confirming that the resin layer 160 has a concavo-convex shape on the surface, or mass production may be performed according to a selected condition that the resin layer 160 has a concavo-convex shape on the surface after selecting the condition.

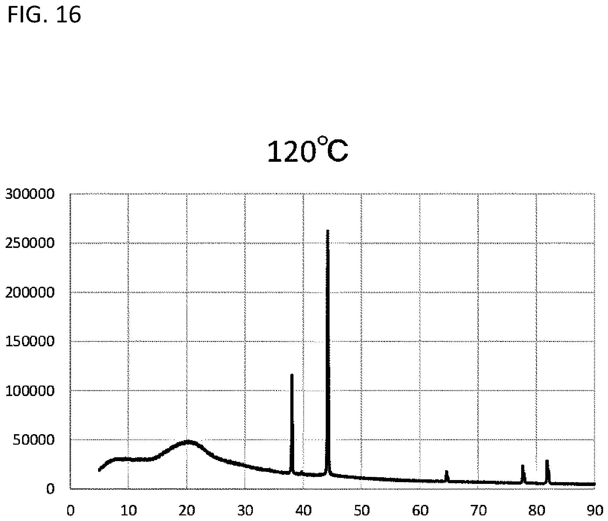

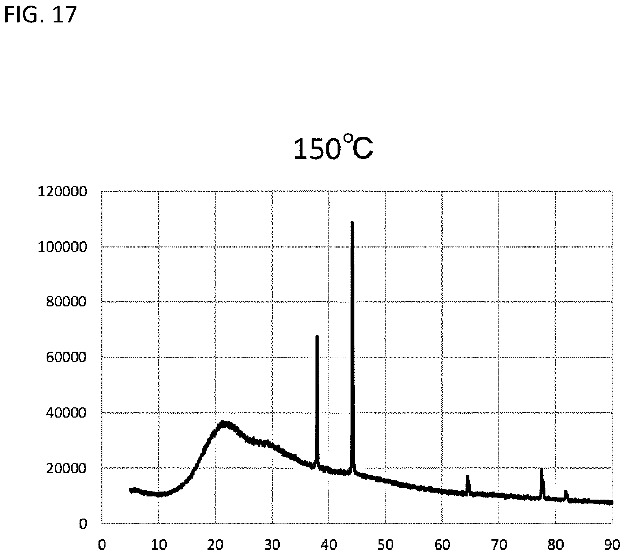

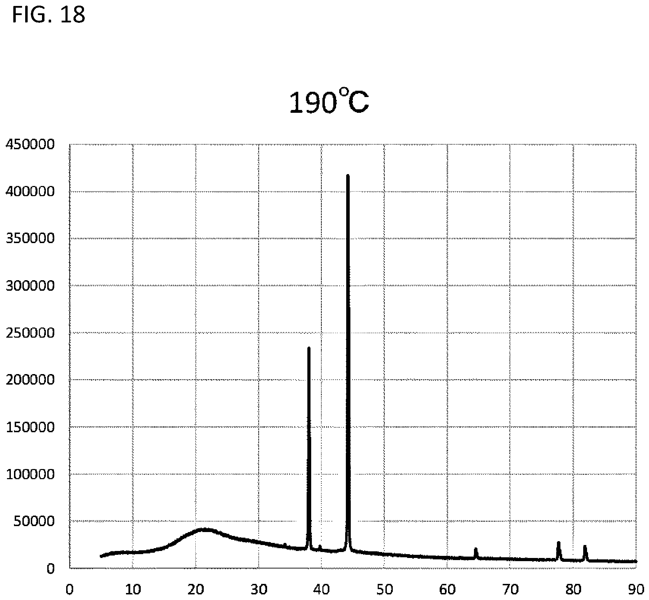

In X-ray diffraction (XRD) measurement results, it was confirmed that a peak value is high at 120°C (see Fig. 16) that is a low temperature at which the semi-cured state is not sufficient and at 190°C (see Fig. 18) that is a high temperature at which curing is progressing, and the peak value is small in a state in which semi-curing is progressing to an appropriate degree as in Figs. 14A and 14B (see Fig. 18). As compared with Fig. 18 in which curing is progressing, in Fig. 18 in which semi-curing is progressing to an appropriate degree, a peak intensity is about 1/4. Therefore, it is advantageous to use the prepreg in the semi-cured state in which the peak intensity of the largest peak in XRD is 1/3 or less (preferably 1/4 or less) as compared with the peak intensity of the largest peak for the cured state in XRD (a peak near 44 degrees in Figs. 17 and 18).

According to the present embodiment, an aspect in which the thickness of the metal layer 20 is small can be adopted, and the thickness of the metal layer 20 may be 10 um or less, 8 um or less, 5 um or less, 3 um or less, or 1 um or less. As the thickness of the metal layer 20 decreases, the need for the carrier layer increases. However, in the present embodiment, the necessity of using the carrier layer is eliminated by directly providing the metal layer 20 having no carrier layer on the prepreg 10 in the semi-cured state.

As an example, as illustrated in Fig. 7, while the prepreg 10 in the semi-cured state is conveyed by a conveyance unit 310 such as a belt conveyor, the metal layer 20 made of a copper foil or the like is provided on the prepreg 10 by a feeding unit 320 such as a feeding roller, whereby the prepreg with a metal layer can be manufactured.

In a case where the metal layers 20 are provided on both surfaces, as illustrated in Fig. 7, the metal layer 20 may be provided on one surface of the prepreg 10, and then the prepreg 10 having one surface on which the metal layer 20 is provided may be reversed to further provide the metal layer 20 (see Fig. 8).

The configuration may be reversed. While the metal layer is conveyed by the conveyance unit 310 such as a belt conveyor, the resin is provided on the metal layer by the feeding unit 320 such as a feeding roller, whereby the prepreg with a metal layer may be manufactured (see Figs. 7 and 8).

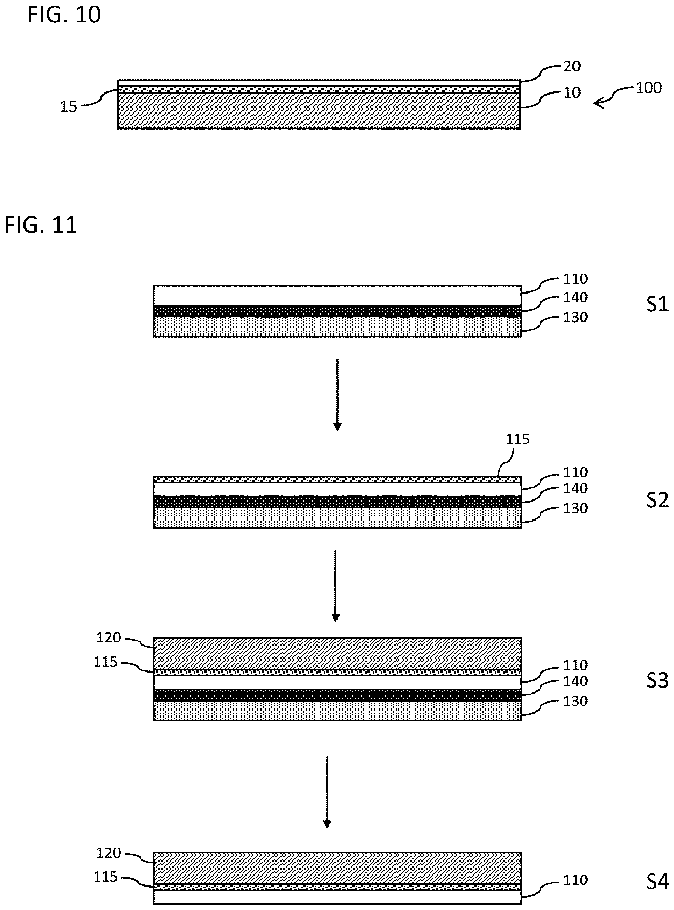

An oxide layer 15 obtained by oxidizing a part of the metal layer 20 may be provided on a surface of the metal layer 20 that faces the prepreg 10 (see Fig. 10). In a case where the metal layer 20 is made of copper, the oxide layer 15 may be made of copper oxide. The copper oxide may be copper monoxide (copper(I) oxide) or copper dioxide (copper(II) oxide). Since copper dioxide is produced by further oxidizing copper monoxide, a ratio of copper monoxide to copper dioxide may be adjusted by adjusting the degree of oxidation of copper monoxide, or the metal layer 20 may be made of only copper dioxide. Instead of the oxide layer 15 of the metal layer 20, a reduction layer obtained by reducing the metal layer 20 may be provided.

In the present embodiment, the following aspects can be provided.
(1) A cupper clad laminate (CCL) (metal-clad laminate) of a semi-cured prepreg
(2) A CCL with a metal foil (metal layer) having a thickness of 11 um or less
(3) A semi-cured CCL including an electroless plating layer, a homogeneous metal paste layer, or both of the electroless plating layer and the homogeneous metal paste layer
(4) A semi-cured CCL including no palladium component and including an electroless plating layer
(5) A semi-cured prepreg CCL in which an adhesion layer is made of an oxide precipitated from a metal foil and an anchor is formed

According to the present embodiment, for example, the following effects can be obtained.

Since it is not necessary to separately procure and use an uncured prepreg (raw material) and a metal foil, the cost for cutting each material (the prepreg and the metal foil), the burden of processing an end part of the prepreg, and the burden of temperature and humidity management requiring a refrigerator, corrosion prevention management, and the like are eliminated, and the cost can be significantly suppressed. In addition, damage due to a defective product in these processes does not occur.

Furthermore, a process of handling these and a carrier material used at that time are also unnecessary. Therefore, it is also possible to eliminate the need for a layup operation of overlapping these.

In addition, it is possible to reduce circuit misalignment between an inner layer and an outer layer occurring in the method according to the related art, and leakage from both ends of the resin at the time of pressurization and heating, that is, resin sagging, and the quality stability in the process is improved.

In addition, in a case where a CCL with a thin metal foil is adopted, it is not necessary to use an expensive metal foil with a carrier, and various processes at that time can be omitted.

In addition, according to the related art, it is very difficult to manufacture a CCL using a thin copper foil having a thickness of 12 um or less, and a CCL obtained by stacking a metal having a thickness of 10 um or less does not exist as a product. Even if such a CCL is formed, it is necessary to employ an electroless plating method, and there is a problem that a technology for forming an anchor exhibiting a sufficient peel strength has not been established in this method. In addition, there is a palladium residue at the time of electroless plating, and there has been a possibility of causing serious defects such as migration when the CCL is circuited later. However, according to an aspect of the present embodiment, such a problem can be solved.

In the present embodiment, as an example, the following manufacturing method is provided (see Fig. 11).

A carrier plate 130 that constitutes a planar carrier layer is prepared, and an adhesive 140 that is thermally degraded (that is, an adhesive force is weakened by application of heat) is applied (see S1 of Fig. 11). A plating inducing material for forming a nonconductor such as silver or palladium into a conductor is mixed thereon and put in a plating layer 110. The plating layer 110 is formed by electroless plating or electrolytic plating. At this time, when the plating layer 110 having a constant thickness is formed, an electrode may be attached and electroplating may be performed to increase the thickness. The plating layer 110 is made of, for example, a copper foil. The anchor may be formed on a copper foil surface by a conventional method used by a copper foil manufacturer, or brown treatment may be performed. Alternatively, the oxide layer 115 may be formed by making an oxide be precipitated on a resulting plating layer made of copper (for example, in a case of copper, a treatment of making cuprous oxide or cupric oxide be precipitated on the surface thereof is performed) (see S2 in Fig. 11). When the oxide is precipitated on the plating copper foil as described above, a convexoconcave and a cavity are formed on an upper surface thereof. The carrier layer may be made of a resin, a metal, a ceramic, or the like.

For example, the plating layer 110 made of a copper foil is brought into contact with a prepreg (a soft thermosetting resin sheet called a raw material) 120, and pressurized and heated (see S3 in Fig. 11). The adhesive 140 on the carrier side is decomposed by thermal degradation, and conversely, the metal-plated upper part side is integrated while the precipitated oxide of the convexoconcave and cavity bite into the soft prepreg to achieve a high peel strength. The prepreg eventually becomes hard due to an influence of heat, and the metal-clad laminate thus formed can be easily peeled off from the carrier plate (see S4 in Fig. 11).

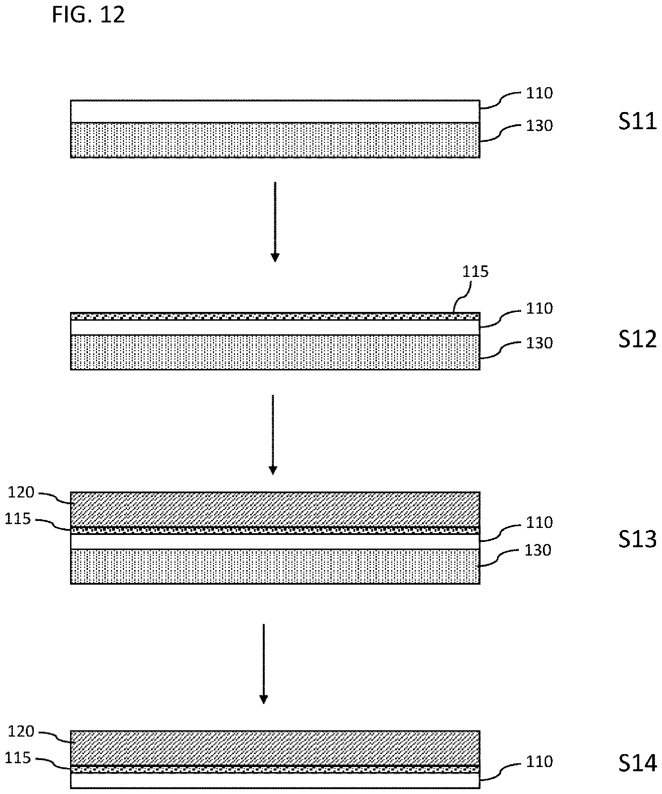

In the present embodiment, as another example, the following manufacturing method is provided (see Fig. 12).

The carrier plate 130 that constitutes a carrier layer having a surface that is easily peeled off, such as a mirror surface, is prepared. The plating layer 110 is formed on the mirror surface of the carrier plate 130 by electrolytic plating or electroless plating (see S11 in Fig. 12) .

At this time, when an upper surface of the plating layer 110 is oxidized and an oxide is precipitated on the upper surface of the plating layer 110, a convexoconcave and a cavity are formed on the upper surface. In this way, the oxide layer 115 is formed (see S12 in Fig. 12).

For example, the plating layer 110 made of a copper foil is brought into contact with the prepreg (a soft thermosetting resin sheet called a raw material) 120, and pressurized and heated (see S13 in Fig. 12). At this time, the metal-plated upper part side is integrated while the precipitated oxide of the convexoconcave and cavity bite into the soft prepreg to achieve a high peel strength. The prepreg eventually becomes hard due to an influence of heat, and the metal-clad laminate thus obtained can be easily peeled off from the carrier plate (see S14 in Fig. 12) .

The CCL thus obtained is advantageous not only for a CCL of a copper foil having a thickness of more than 11 um but also for a metal-clad laminate having a thickness of 11 um or less. It is possible to manufacture a CCL using a thin copper foil in which defects such as migration, in particular, of palladium do not occur and a sufficient peel strength is achieved even when the copper foil has a thickness of several um. When an aspect in which a copper foil is oxidized (an aspect in which the oxide layer 115 is provided) is used, an anchor surface is formed by a convexoconcave of an insulator such as a precipitated oxide, and a cross section of the copper foil that is not oxidized does not substantially have a concavo-convex shape. Therefore, since a conductor layer side is a smooth plane, an electrical resistance is reduced, and a high frequency characteristic is also improved. In addition, by providing such an oxide layer 115, when etching is performed, it is possible to form a circuit having a cross section whose shape is different from a trapezoidal shape and is close to a square shape or a rectangular shape unlike the related art (cutting can be cleanly performed). Therefore, it is also possible to cause a current close to a design value to flow in the formed circuit.

In addition, it is possible to form a metal-clad laminate without leaving a plating inducing material layer such as silver or palladium anywhere in the CCL, which has been required for electroless plating and has been a problem of the related art, and without using a thin metal foil which can form a CCL having a peel strength sufficient to make an oxide precipitate surface serve as the anchor, and is particularly difficult to handle.

As a result of forming the anchor by precipitation of an insulating material such as an oxide, the conductor layer side becomes a smooth plane, so that it is possible to manufacture a CCL with an increased electrical resistance on the anchor surface of the conductor layer and an improved frequency characteristic. It is a matter of course that a metal-clad laminate having a thickness of 10 um or more may be used. The present invention is applicable to manufacturing of a metal layer having any thickness and a substrate having any thickness and any number of layers.

The prepreg with a metal layer in the above-described embodiment may be provided with an electronic component such as a semiconductor element, a capacitor, or a resistor. The electronic component may be sealed by a sealing part to provide an electronic apparatus (including a package) such as an IC package or an electronic device. Such an electronic apparatus may be incorporated into any mounting apparatus such as an automobile, an airplane, a ship, a helicopter, a personal computer, or a home appliance. The product of the present embodiment may include any object such as an electronic component, a device, an electrical product, a communication device, or a vehicle.

The description of embodiment and variation, and the disclosure of the figures described above are merely examples for describing the invention described in the claims, and the invention described in the claims is not limited by the description of the embodiments or the disclosure of the figures described above.

### REFERENCE SIGNS LIST

- 10: Prepreg
- 20: Metal layer
- 100: Prepreg with metal layer
- 200: Multilayer plate

## Claims

1. A prepreg with a metal layer comprising:
the metal layer having a thickness of 11 um or less; and
the prepreg provided on the metal layer,
wherein a carrier layer for supporting the metal layer is not provided.

2. The prepreg with the metal layer according to claim 1,
wherein the prepreg has a fiber layer and a resin layer provided on the fiber layer, and
wherein the resin layer is in a semi-cured state and has a surface having a concavo-convex shape.

3. The prepreg with the metal layer according to claim 1 or 2,
wherein a peak intensity of the largest peak in XRD measurement for the resin layer of the prepreg is 1/3 or less as compared with a peak intensity of the largest peak in XRD measurement for the prepreg in which the resin layer is completely cured.

4. The prepreg with the metal layer according to any one of claims 1 to 3,
wherein the metal layer has a thickness of 5 um or less.

5. The prepreg with the metal layer according to any one of claims 1 to 3,
wherein the metal layer has a thickness of 3 um or less.

6. The prepreg with the metal layer according to any one of claims 1 to 3,
wherein the metal layer has a thickness of 1 um or less.

7. The prepreg with the metal layer according to any one of claims 1 to 6,
wherein metal layers are provided on both surfaces of the prepreg.

8. A laminate manufacturing method for manufacturing a laminate by laminating the prepregs with the metal layers according to any one of claims 1 to 7.

9. A method for manufacturing a prepreg with a metal layer comprising:
a step of forming the metal layer on a carrier layer having a surface on which an adhesive that is thermally degraded is provided;
a step of providing a thermosetting prepreg on a surface of the metal layer opposite from the carrier layer;
a step of curing the prepreg and degrading the adhesive by heating; and
a step of removing the carrier layer and the adhesive.

10. The method according to claim 9 further comprising a step of oxidizing or reducing the surface of the metal layer opposite from the carrier layer between the step of forming the metal layer and the step of providing the prepreg.

11. A method for manufacturing a prepreg with a metal layer comprising:
a step of forming the metal layer on a mirror surface that a carrier layer has;
a step of providing a thermosetting prepreg on a surface of the metal layer opposite from the carrier layer; and
a step of removing the carrier layer.

12. The method according to any one of claims 9 to 11, wherein the step of forming the metal layer is performed by electroless plating or electrolytic plating.
